# EUROPEAN PATENT APPLICATION

(11) **EP 4 661 083 A1**
(43) Date of publication of application: **10.12.2025**
(21) Application number: 24777815.2
(22) Date of filing: 20.03.2024
(51) Int. Cl.: H01L 31/18, H01L 31/20, H01L 31/0236, H01L 31/0352, H01L 31/0376, H01L 31/0368, H01L 31/06

(54) **SOLAR CELL PREPARATION METHOD AND SOLAR CELL**

(30) Priority: 24.03.2023 CN 202310304298
(71) Applicant: Tongwei Solar (Chengdu) Co., Ltd., Chengdu, Sichuan 610299 (CN)
(72) Inventor: HAN, Zongyu, Chengdu, Sichuan 610299 (CN)
(74) Representative: Zacco Denmark A/S
(86) International application number: PCT/CN2024/082610
(87) International publication number: WO 2024/199026

(57) **Abstract**

The present application relates to a solar cell preparation method and a solar cell. The solar cell preparation method comprises: providing a silicon substrate (100) having non-textured surfaces; preparing intrinsic amorphous silicon layers on the two non-textured surfaces of the silicon substrate (100); respectively preparing an n-type microcrystalline doped layer and a p-type microcrystalline doped layer on the surfaces of the two intrinsic amorphous silicon layers; and texturing the surfaces of the n-type microcrystalline doped layer and the p-type microcrystalline doped layer.

## Description

This application claims priority to Chinese patent application No. 202310304298.4, entitled "SOLAR CELL PREPARATION METHOD AND SOLAR CELL" filed on March 24, 2023, the content of which is hereby incorporated by reference in its entirety.

### TECHNICAL FIELD

The present disclosure relates to the technical field of solar cells, and in particular to a method for preparing a solar cell, and a solar cell.

### BACKGROUND

With the continuous improvement of the efficiency of solar cells, the cell efficiency is mainly limited by the short-circuit current (Isc) loss in the doped amorphous silicon film layer, while the doped microcrystalline silicon film exhibits better carrier transport characteristics, lower parasitic absorption, and a better carrier-selective interface, thereby improving the conversion efficiency of the solar cell. In the conventional process of growing a microcrystalline thin film on a substrate, texturing is firstly made on the silicon substrate, then an ultra-thin intrinsic amorphous silicon thin film is disposed to passivate dangling bonds on the surface of the silicon substrate, enabling the solar cell to have a high open-circuit voltage (Uoc) to improve efficiency. However, a pyramid textured surface generated by texturing on the silicon substrate by wet chemical reaction shows a much larger size than the thickness of the intrinsic amorphous silicon thin film, making it difficult for the intrinsic amorphous silicon thin film to contact the silicon substrate completely and forming defects on the surface of the intrinsic amorphous silicon thin film, so that it easily leads to direct contact between the doped microcrystalline silicon thin film and the silicon substrate, causing a decrease in the open-circuit voltage (Uoc).

### SUMMARY

Based on this, it is necessary to provide a method for preparing a solar cell, and a solar cell. The method for preparing the solar cell can improve the contact effect between the intrinsic amorphous silicon thin film and the silicon substrate, and reduce the risk of direct contact between the doped microcrystalline silicon thin film and the silicon substrate, thereby improving the open-circuit voltage to enhance the cell efficiency.

In a first aspect, the present disclosure provides a method for preparing a solar cell, including:
providing a silicon substrate with untextured surfaces;
preparing intrinsic amorphous silicon layers on both surfaces of the untextured silicon substrate;
preparing an n-type microcrystalline doped layer and a p-type microcrystalline doped layer on surfaces of the two intrinsic amorphous silicon layers, respectively; and
performing texturing on surfaces of the n-type microcrystalline doped layer and the p-type microcrystalline doped layer.

In some embodiments, preparing the n-type microcrystalline doped layer and the p-type microcrystalline doped layer on the surfaces of the two intrinsic amorphous silicon layers, respectively, includes:
preparing an n-type amorphous doped sublayer and a p-type amorphous doped sublayer on the surfaces of the two intrinsic amorphous silicon layers, respectively;
preparing an n-type microcrystalline growth sublayer on the n-type amorphous doped sublayer, and preparing a p-type microcrystalline growth sublayer on the p-type amorphous doped sublayer; and
preparing an n-type microcrystalline doped sublayer on the n-type microcrystalline growth sublayer, and preparing a p-type microcrystalline doped sublayer on the p-type microcrystalline growth sublayer.

In some embodiments, performing texturing on the surfaces of the n-type microcrystalline doped layer and the p-type microcrystalline doped layer includes:
performing texturing on the surfaces of the n-type microcrystalline doped layer and the p-type microcrystalline doped layer at 60°C to 65°C using an alkaline solution with a mass concentration of 0.8% to 1%.

In some embodiments, a thickness of the n-type microcrystalline doped sublayer is controlled to be 0.5 µm to 1 µm.

In some embodiments, a thickness of the p-type microcrystalline doped sublayer is controlled to be 0.5 µm to 1 µm.

In some embodiments, a pressure for preparing the n-type amorphous doped sublayer is 0.5 Torr to 0.57 Torr.

In some embodiments, a volume ratio of gases for preparing the n-type amorphous doped sublayer is SiH₄:H₂=1:15 to 1:30.

In some embodiments, an ignition power for preparing the n-type amorphous doped sublayer is 200 W to 800 W.

In some embodiments, a pressure for preparing the p-type amorphous doped sublayer is 0.5 Torr to 0.57 Torr.

In some embodiments, a volume ratio of gases for preparing the p-type amorphous doped sublayer is SiH₄:H₂=1:15 to 1:30.

In some embodiments, an ignition power for preparing the p-type amorphous doped sublayer is 200 W to 800 W.

In some embodiments, a pressure for preparing the n-type microcrystalline growth sublayer on the n-type amorphous doped sublayer is 3 Torr to 5 Torr.

In some embodiments, a volume ratio of gases for preparing the n-type microcrystalline growth sublayer on the n-type amorphous doped sublayer is SiH₄:H₂=1:150 to 1:200.

In some embodiments, an ignition power for preparing the n-type microcrystalline growth sublayer on the n-type amorphous doped sublayer is 2000 W to 3500 W.

In some embodiments, a pressure for preparing the p-type microcrystalline growth sublayer on the p-type amorphous doped sublayer is 3 Torr to 5 Torr.

In some embodiments, a volume ratio of gases for preparing the p-type microcrystalline growth sublayer on the p-type amorphous doped sublayer is SiH₄:H₂=1:150 to 1:200.

In some embodiments, an ignition power for preparing the p-type microcrystalline growth sublayer on the p-type amorphous doped sublayer is 2000 W to 3500 W.

In some embodiments, a pressure for preparing the n-type microcrystalline doped sublayer on the n-type microcrystalline growth sublayer is 5 Torr to 8 Torr.

In some embodiments, an ignition power for preparing the n-type microcrystalline doped sublayer on the n-type microcrystalline growth sublayer is 4000 W to 7000 W.

In some embodiments, a pressure for preparing the p-type microcrystalline doped sublayer on the p-type microcrystalline growth sublayer is 5 Torr to 8 Torr.

In some embodiments, an ignition power for preparing the p-type microcrystalline doped sublayer on the p-type microcrystalline growth sublayer is 4000 W to 7000 W.

In some embodiments, before the preparing the intrinsic amorphous silicon layers on both surfaces of the untextured silicon substrate, the method further includes:

performing rough polishing, pre-cleaning, polishing, and passivation on the untextured silicon substrate sequentially.

In some embodiments, a thickness of each of the two intrinsic amorphous silicon layers is controlled to be 5 nm to 10 nm.

In a second aspect, the present disclosure further provides a solar cell, including: a untextured silicon substrate; intrinsic amorphous silicon layers respectively disposed on both surfaces of the non-textured silicon substrate; and an n-type microcrystalline doped layer and a p-type microcrystalline doped layer respectively disposed on surfaces of the two intrinsic amorphous silicon layers away from the untextured silicon substrate, wherein surfaces of the n-type microcrystalline doped layer and the p-type microcrystalline doped layer away from the untextured silicon substrate are textured surfaces.

In some embodiments, the n-type microcrystalline doped layer includes an n-type amorphous doped sublayer, an n-type microcrystalline growth sublayer, and an n-type microcrystalline doped sublayer sequentially stacked, wherein the n-type amorphous doped sublayer is closer to the untextured silicon substrate than the n-type microcrystalline doped sublayer; and the p-type microcrystalline doped layer includes a p-type amorphous doped sublayer, a p-type microcrystalline growth sublayer, and a p-type microcrystalline doped sublayer sequentially stacked, wherein the p-type amorphous doped sublayer is closer to the untextured silicon substrate than the p-type microcrystalline doped sublayer.

In some embodiments, a thickness of the n-type microcrystalline doped sublayer is 0.5 µm to 1 µm.

In some embodiments, a thickness of the p-type microcrystalline doped sublayer is 0.5 µm to 1 µm.

In some embodiments, the textured surface has a plurality of pyramid structures, and a height of the pyramid structure is 0.5 µm to 1 µm.

According to the above preparing method for a solar cell, no texturing is performed on the silicon substrate, but the intrinsic amorphous silicon layers are prepared on the surfaces of the non-textured silicon substrate, then the n-type microcrystalline doped layer and the p-type microcrystalline doped layer are prepared on the surfaces of the two intrinsic amorphous silicon layers, respectively, and finally texturing is performed on the surfaces of the n-type microcrystalline doped layer and the p-type microcrystalline doped layer. Preparing the intrinsic amorphous silicon layer on the surface of the non-textured silicon substrate enables the intrinsic amorphous silicon layer and the silicon substrate to contact more completely, while performing texturing on the surfaces of the n-type microcrystalline doped layer and the p-type microcrystalline doped layer achieves a light trapping effect, thereby improving the light utilization efficiency of the solar cell. This method can improve the contact effect between the intrinsic amorphous silicon thin film and the silicon substrate, reduce the risk of direct contact between the doped microcrystalline silicon thin film and the silicon substrate, thereby enhancing the conversion efficiency of the solar cell.

### BRIEF DESCRIPTION OF THE DRAWINGS

FIG. 1 is a schematic view of a method for preparing a solar cell provided in an embodiment of the present disclosure.
FIG. 2 is a schematic view of a film structure of the solar cell provided in an embodiment of the present disclosure.

### Description of Reference Numerals

100: silicon substrate; 210: n-type intrinsic amorphous silicon layer; 220: p-type intrinsic amorphous silicon layer; 310: n-type microcrystalline incubation sublayer; 320: p-type microcrystalline incubation sublayer; 410: n-type microcrystalline doped sublayer; 420: p-type microcrystalline doped sublayer; 510: front transparent conductive oxide layer; 520: back transparent conductive oxide layer; 610: front electrode layer; 620: back electrode layer.

### DETAILED DESCRIPTION

In order to make the above purposes, features, and advantages of the present disclosure more apparent and understandable, a detailed description of the specific embodiments of the present disclosure will be given below in conjunction with the accompanying drawings. Many specific details are set forth in the following description to facilitate a full understanding of the present disclosure. However, the present disclosure can be implemented in many ways different from the embodiments described herein, and those skilled in the art can make similar improvements without departing from the content of the present disclosure. Therefore, the present disclosure is not limited by the specific embodiments disclosed below.

Unless otherwise defined, all technical and scientific terms used herein have the same meaning as commonly understood by persons skilled in the art to which the present invention belongs. The terms used in the specification of the present disclosure are for the purpose of describing the specific embodiments only, and are not intended to limit the present disclosure. The term "and/or" used herein includes any and all combinations of one or more of the associated listed items.

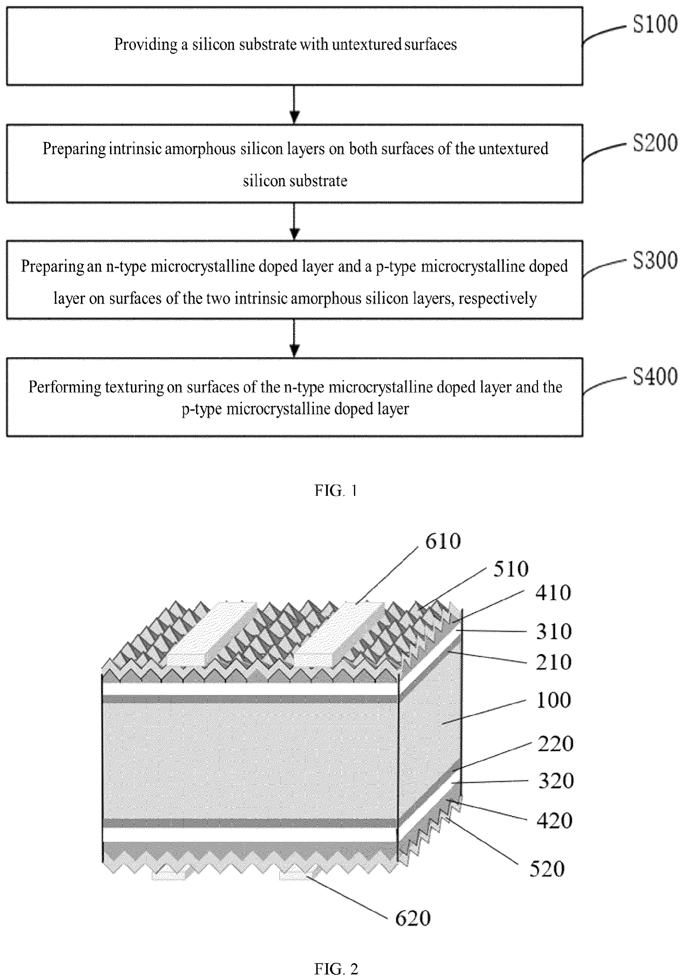

Referring to FIG. 1, an embodiment of the present disclosure provides a method for preparing a solar cell, including:
S100: providing a silicon substrate with untextured surfaces;
S200: preparing intrinsic amorphous silicon layers on both surfaces of the untextured silicon substrate;
S300: preparing an n-type microcrystalline doped layer and a p-type microcrystalline doped layer on surfaces of the two intrinsic amorphous silicon layers, respectively; and
S400: performing texturing on surfaces of the n-type microcrystalline doped layer and the p-type microcrystalline doped layer.

According to the above preparing method for a solar cell, no texturing is performed on the silicon substrate, but the intrinsic amorphous silicon layers are prepared on the surfaces of the non-textured silicon substrate, then the n-type microcrystalline doped layer and the p-type microcrystalline doped layer are prepared on the surfaces of the two intrinsic amorphous silicon layers, respectively, and finally texturing is performed on the surfaces of the n-type microcrystalline doped layer and the p-type microcrystalline doped layer. Preparing the intrinsic amorphous silicon layer on the surface of the non-textured silicon substrate enables the intrinsic amorphous silicon layer and the silicon substrate to contact more completely, while performing texturing on the surfaces of the n-type microcrystalline doped layer and the p-type microcrystalline doped layer achieves a light trapping effect, thereby improving the light utilization efficiency of the solar cell. This method can improve the contact effect between the intrinsic amorphous silicon thin film and the silicon substrate, reduce the risk of direct contact between the doped microcrystalline silicon thin film and the silicon substrate, thereby enhancing the conversion efficiency of the solar cell.

In an embodiment, the silicon substrate is an n-type monocrystalline silicon wafer.

In an embodiment, the intrinsic amorphous silicon layer is prepared by plasma chemical vapor deposition.

In an embodiment, the method for preparing a solar cell includes:
providing a silicon substrate with untextured surfaces;
preparing intrinsic amorphous silicon layers on both surfaces of the untextured silicon substrate;
preparing an n-type microcrystalline doped layer and a p-type microcrystalline doped layer on surfaces of the two intrinsic amorphous silicon layers, respectively; and
performing texturing on surfaces of the n-type microcrystalline doped layer and the p-type microcrystalline doped layer.

In some embodiments, preparing the n-type microcrystalline doped layer and the p-type microcrystalline doped layer on the surfaces of the two intrinsic amorphous silicon layers, respectively, includes: preparing an n-type amorphous doped sublayer and a p-type amorphous doped sublayer on the surfaces of the two intrinsic amorphous silicon layers, respectively; preparing an n-type microcrystalline growth sublayer on the n-type amorphous doped sublayer, and preparing a p-type microcrystalline growth sublayer on the p-type amorphous doped sublayer; and preparing an n-type microcrystalline doped sublayer on the n-type microcrystalline growth sublayer, and preparing a p-type microcrystalline doped sublayer on the p-type microcrystalline growth sublayer. First, the amorphous doped layer is prepared on the intrinsic amorphous silicon layer. The amorphous doped layer can serve as an incubation layer for the microcrystalline film layer. Then, the microcrystalline growth layer is prpared on the amorphous doped layer. By increasing power, growth of the film layer can be transformed from amorphous to microcrystalline. After the preparation of the microcrystalline growth layer is completed, a high-thickness microcrystalline doped layer with a relatively large thickness is prepared on the surface of the microcrystalline growth layer to provide conditions for texturing.

In an embodiment, the n-type amorphous doped sublayer is prepared by plasma chemical vapor deposition.

In an embodiment, the p-type amorphous doped sublayer is prepared by plasma chemical vapor deposition.

In an embodiment, the n-type microcrystalline growth sublayer is prepared by plasma chemical vapor deposition.

In an embodiment, the p-type microcrystalline growth sublayer is prepared by plasma chemical vapor deposition.

In an embodiment, the n-type microcrystalline doped sublayer is prepared by plasma chemical vapor deposition.

In an embodiment, the p-type microcrystalline doped sublayer is prepared by plasma chemical vapor deposition.

In some embodiments, performing texturing on the surfaces of the n-type microcrystalline doped layer and the p-type microcrystalline doped layer includes:
performing texturing on the surfaces of the n-type microcrystalline doped layer and the p-type microcrystalline doped layer at 60°C to 65°C using an alkaline solution with a mass concentration of 0.8% to 1%. Optionally, the mass concentration of the alkaline solution for performing texturing on the surfaces of the n-type microcrystalline doped layer and the p-type microcrystalline doped layer is 0.8%, 0.81%, 0.82%, 0.83%, 0.84%, 0.85%, 0.86%, 0.87%, 0.88%, 0.89%, 0.9%, 0.91%, 0.92%, 0.93%, 0.94%, 0.95%, 0.96%, 0.97%, 0.98%, 0.99%, or 1%. Optionally, the temperature for texturing the surfaces of the n-type microcrystalline doped layer and the p-type microcrystalline doped layer is 60°C, 60.5°C, 61°C, 61.5°C, 62°C, 62.5°C, 63°C, 63.5°C, 64°C, 64.5°C, or 65°C.

In some embodiments, a thickness of the n-type microcrystalline doped sublayer is controlled to be 0.5 µm to 1 µm. Within this thickness range of the n-type microcrystal doped sublayer, subsequent texturing achieves a better effect. Optionally, the thickness of the n-type microcrystalline doped sublayer is controlled to be 0.5 µm, 0.55 µm, 0.6 µm, 0.65 µm, 0.7 µm, 0.75 µm, 0.8 µm, 0.85 µm, 0.9 µm, 0.95 µm, or 1 µm.

In some embodiments, a thickness of the p-type microcrystalline doped sublayer is controlled to be 0.5 µm to 1 µm. Within this thickness range of the p-type microcrystal doped sublayer, subsequent texturing achieves a better effect. Optionally, the thickness of the p-type microcrystalline doped sublayer is controlled to be 0.5 µm, 0.55 µm, 0.6 µm, 0.65 µm, 0.7 µm, 0.75 µm, 0.8 µm, 0.85 µm, 0.9 µm, 0.95 µm, or 1 µm.

In some embodiments, a pressure for the preparation of the n-type amorphous doped sublayer is 0.5 Torr to 0.57 Torr. At a relatively low pressure, combined with a relatively low volume ratio of silane to hydrogen and a relatively low ignition power, the amorphous doped film layer can be deposited, which serves as an incubation layer for the subsequent microcrystalline film layer. Optionally, the pressure for the preparation of the n-type amorphous doped sublayer is 0.5 Torr, 0.51 Torr, 0.52 Torr, 0.53 Torr, 0.54 Torr, 0.55 Torr, 0.56 Torr, or 0.57 Torr.

In some embodiments, a volume ratio of gases for the preparation of the n-type amorphous doped sublayer is SiH₄:H₂=1:15 to 1:30. At a relatively low volume ratio of silane to hydrogen, combined with a relatively low pressure and a relatively low ignition power, the amorphous doped film layer can be deposited, which serves as an incubation layer for the subsequent microcrystalline film layer. The volume ratio of gases for the preparation of the n-type amorphous doped sublayer is SiH₄:H₂=1:15, 1:16, 1:17, 1:18, 1:19, 1:20, 1:21, 1:22, 1:23, 1:24, 1:25, 1:26, 1:27, 1:28, 1:29, or 1:30.

In some embodiments, an ignition power for the preparation of the n-type amorphous doped sublayer is 200 W to 800 W. At a relatively low ignition power, combined with a relatively low pressure and a relatively low volume ratio of silane to hydrogen, the amorphous doped film layer can be deposited, which serves as an incubation layer for the subsequent microcrystalline film layer. Optionally, the ignition power for the preparation of the n-type amorphous doped sublayer is 200 W, 250 W, 300 W, 350 W, 400 W, 450 W, 500 W, 550 W, 600 W, 650 W, 700 W, 750 W, or 800 W.

In some embodiments, a pressure for the preparation of the p-type amorphous doped sublayer is 0.5 Torr to 0.57 Torr. At a relatively low pressure, combined with a relatively low volume ratio of silane to hydrogen and a relatively low ignition power, the amorphous doped film layer can be deposited, which serves as an incubation layer for the subsequent microcrystalline film layer. Optionally, the pressure for the preparation of the p-type amorphous doped sublayer is 0.5 Torr, 0.51 Torr, 0.52 Torr, 0.53 Torr, 0.54 Torr, 0.55 Torr, 0.56 Torr, or 0.57 Torr.

In some embodiments, a volume ratio of gases for the preparation of the p-type amorphous doped sublayer is SiH₄:H₂=1:15 to 1:30. At a relatively low volume ratio of silane to hydrogen, combined with a relatively low pressure and a relatively low ignition power, the amorphous doped film layer can be deposited, which serves as an incubation layer for the subsequent microcrystalline film layer. The volume ratio of gases for the preparation of the p-type amorphous doped sublayer is SiH₄:H₂=1:15, 1:16, 1:17, 1:18, 1:19, 1:20, 1:21, 1:22, 1:23, 1:24, 1:25, 1:26, 1:27, 1:28, 1:29, or 1:30.

In some embodiments, an ignition power for the preparation of the p-type amorphous doped sublayer is 200 W to 800 W. At a relatively low ignition power, combined with a relatively low pressure and a relatively low volume ratio of silane to hydrogen, the amorphous doped film layer can be deposited, which serves as an incubation layer for the subsequent microcrystalline film layer. Optionally, the ignition power for the preparation of the p-type amorphous doped sublayer is 200 W, 250 W, 300 W, 350 W, 400 W, 450 W, 500 W, 550 W, 600 W, 650 W, 700 W, 750 W, or 800 W.

In some embodiments, a pressure for the preparation of the n-type microcrystalline growth sublayer on the n-type amorphous doped sublayer is 3 Torr to 5 Torr. By increasing the pressure, the growth of the film layer can be transformed from amorphous growth to microcrystalline growth. Within this pressure range, the growth of the microcrystalline film layer achieves a better effect, and the crystalline fraction of the film layer is also higher. Optionally, the pressure for the preparation of the n-type microcrystalline growth sublayer on the n-type amorphous doped sublayer is 3 Torr, 3.2 Torr, 3.4 Torr, 3.6 Torr, 3.8 Torr, 4 Torr, 4.2 Torr, 4.4 Torr, 4.6 Torr, 4.8 Torr, or 5 Torr.

In some embodiments, a volume ratio of gases for the preparation of the n-type microcrystalline growth sublayer on the n-type amorphous doped sublayer is SiH₄:H₂=1:150 to 1:200. Optionally, the volume ratio of SiH₄ to H₂ in the preparation of the n-type microcrystalline growth sublayer on the n-type amorphous doped sublayer is 1:150, 1:155, 1:160, 1:156, 1:170, 1:175, 1:180, 1:185, 1:190, 1:195, or 1: 200.

In some embodiments, an ignition power for the preparation of the n-type microcrystalline growth sublayer on the n-type amorphous doped sublayer is 2000 W to 3500 W. By increasing the ignition power, the growth of the film layer can be transformed from amorphous growth to microcrystalline growth at the high power. Within this ignition power range, the growth of the microcrystalline film layer achieves a better effect, and the crystalline fraction of the film layer is also higher. Optionally, the ignition power for the preparation of the n-type microcrystalline growth sublayer on the n-type amorphous doped sublayer is 2000 W, 2100 W, 2200 W, 2300 W, 2400 W, 2500 W, 2600 W, 2700 W, 2800 W, 2900 W, 3000 W, 3100 W, 3200 W, 3300 W, 3400 W, or 3500 W.

In some embodiments, a pressure for the preparation of the p-type microcrystalline growth sublayer on the p-type amorphous doped sublayer is 3 Torr to 5 Torr. By increasing the pressure, the growth of the film layer can be transformed from amorphous growth to microcrystalline growth. Within this pressure range, the growth of the microcrystalline film layer achieves a better effect, and the crystalline fraction of the film layer is also higher. Optionally, the pressure for the preparation of the p-type microcrystalline growth sublayer on the p-type amorphous doped sublayer is 3 Torr, 3.2 Torr, 3.4 Torr, 3.6 Torr, 3.8 Torr, 4 Torr, 4.2 Torr, 4.4 Torr, 4.6 Torr, 4.8 Torr, or 5 Torr.

In some embodiments, a volume ratio of gases for the preparation of the p-type microcrystalline growth sublayer on the p-type amorphous doped sublayer is SiH₄:H₂=1:150 to 1:200. Optionally, the volume ratio of SiH₄ to H₂ in the preparation of the p-type microcrystalline growth sublayer on the p-type amorphous doped sublayer is 1:150, 1:155, 1:160, 1:156, 1:170, 1:175, 1:180, 1:185, 1:190, 1:195, or 1: 200.

In some embodiments, an ignition power for the preparation of the p-type microcrystalline growth sublayer on the p-type amorphous doped sublayer is 2000 W to 3500 W. By increasing the ignition power, the growth of the film layer can be transformed from amorphous growth to microcrystalline growth at the high power. Within this ignition power range, the growth of the microcrystalline film layer achieves a better effect, and the crystalline fraction of the film layer is also higher. Optionally, the ignition power for the preparation of the p-type microcrystalline growth sublayer on the p-type amorphous doped sublayer is 2000 W, 2100 W, 2200 W, 2300 W, 2400 W, 2500 W, 2600 W, 2700 W, 2800 W, 2900 W, 3000 W, 3100 W, 3200 W, 3300 W, 3400 W, or 3500 W.

In some embodiments, a pressure for the preparing the n-type microcrystalline doped sublayer on the n-type microcrystalline growth sublayer is 5 Torr to 8 Torr. By further increasing the pressure for preparation, the n-type microcrystalline doped sublayer is prepared on the n-type microcrystalline growth sublayer. By combining a high pressure with a high power, the growth of the n-type microcrystalline doped sublayer can achieve a better effect, and the n-type microcrystalline doped sublayer has a higher crystalline fraction. This relatively high crystalline fraction can ensure anisotropy during subsequent texturing on the surface of the high-thickness microcrystalline doped layer, resulting in better texturing effects. Optionally, the pressure for the preparation of n-type microcrystalline doped sublayer on the n-type microcrystalline growth sublayer is 5 Torr, 5.5 Torr, 6 Torr, 6.5 Torr, 7 Torr, 7.5 Torr, or 8 Torr.

In some embodiments, an ignition power for the preparation of the n-type microcrystalline doped sublayer on the n-type microcrystalline growth sublayer is 4000 W to 7000 W. By further increasing the ignition power for preparation, the n-type microcrystalline doped sublayer is prepared on the n-type microcrystalline growth sublayer. By combining a high pressure with a high power, the growth of the n-type microcrystalline doped sublayer can achieve a better effect, and the n-type microcrystalline doped sublayer has a higher crystalline fraction. This relatively high crystalline fraction can ensure anisotropy during subsequent texturing on the surface of the high-thickness microcrystalline doped layer, resulting in better texturing effects. Optionally, the ignition power for the preparation of n-type microcrystalline doped sublayer on the n-type microcrystalline growth sublayer is 4000W, 4200W, 4400W, 4600W, 4800W, 5000W, 5200W, 5400W, 5600W, 5800W, 6000W, 6200W, 6400W, 6600W, 6800W, or 7000W.

In some embodiments, a pressure for the preparing the p-type microcrystalline doped sublayer on the p-type microcrystalline growth sublayer is 5 Torr to 8 Torr. By further increasing the pressure for preparation, the p-type microcrystalline doped sublayer is prepared on the p-type microcrystalline growth sublayer. By combining a high pressure with a high power, the growth of the p-type microcrystalline doped sublayer can achieve a better effect, and the p-type microcrystalline doped sublayer has a higher crystalline fraction. This relatively high crystalline fraction can ensure anisotropy during subsequent texturing on the surface of the high-thickness microcrystalline doped layer, resulting in better texturing effects. Optionally, the pressure for the preparation of p-type microcrystalline doped sublayer on the p-type microcrystalline growth sublayer is 5 Torr, 5.5 Torr, 6 Torr, 6.5 Torr, 7 Torr, 7.5 Torr, or 8 Torr.

In some embodiments, an ignition power for the preparation of the p-type microcrystalline doped sublayer on the p-type microcrystalline growth sublayer is 4000 W to 7000 W. By further increasing the ignition power for preparation, the p-type microcrystalline doped sublayer is prepared on the p-type microcrystalline growth sublayer. By combining a high pressure with a high power, the growth of the p-type microcrystalline doped sublayer can achieve a better effect, and the p-type microcrystalline doped sublayer has a higher crystalline fraction. This relatively high crystalline fraction can ensure anisotropy during subsequent texturing on the surface of the high-thickness microcrystalline doped layer, resulting in better texturing effects. Optionally, the ignition power for the preparation of p-type microcrystalline doped sublayer on the p-type microcrystalline growth sublayer is 4000 W, 4200 W, 4400 W, 4600 W, 4800 W, 5000 W, 5200 W, 5400 W, 5600 W, 5800 W, 6000 W, 6200 W, 6400 W, 6600 W, 6800 W, or 7000 W.

It is understood that, in some embodiments, performing texturing on the surfaces of the n-type microcrystalline doped layer and the p-type microcrystalline doped layer is performing texturing on the surfaces of the n-type microcrystalline doped sublayer and the p-type microcrystalline doped sublayer. Performing texturing using an alkaline solution enables anisotropic etching on the surfaces of the n-type microcrystalline doped sublayer and the p-type microcrystalline doped sublayer, forming pyramid-shaped microscopic structures to achieve a light trapping effect and improve cell efficiency. By performing texturing at a relatively low concentration of alkaline solution and at a relatively low temperature, it enables that textured surfaces with small difference are formed on the surfaces of the n-type microcrystalline doped sublayer and the p-type microcrystalline doped sublayer, thereby forming uniform textured surfaces.

In some embodiments, the alkaline solution used to perform texturing on the surfaces of the n-type microcrystalline doped layer and the p-type microcrystalline doped layer further contains an alcohol additive. The alcohol additive can reduce the reaction intensity during texturing, making the reaction gentler, and leading to more uniform texturing effects.

In some embodiments, the alkaline solution includes at least one of a NaOH solution and a KOH solution.

In some embodiments, after performing texturing on the surfaces of the n-type microcrystalline doped layer and the p-type microcrystalline doped layer, the method further includes: treating the surfaces of the n-type microcrystalline doped layer and the p-type microcrystalline doped layer with an HCl solution and an H₂O₂ solution. This treatment step can remove impurities such as residual metal ions and oil contamination due to exposure to air.

In some embodiments, after performing texturing on the surfaces of the n-type microcrystalline doped layer and the p-type microcrystalline doped layer, the method further includes: treating tthe surfaces of the n-type microcrystalline doped layer and the p-type microcrystalline doped layer with an HF solution. This treatment step can remove an oxide layer remaining on the surface due to exposure to air.

In some embodiments, before preparing the intrinsic amorphous silicon layers on both surfaces of the untextured silicon substrate, the method further includes:
performing rough polishing, pre-cleaning, polishing, and passivation on the untextured silicon substrate sequentially.

In some embodiments, the rough polishing includes immersing the surface of the silicon substrate using a strong alkaline solution. The rough polishing can corrode away damages left on the surface of the silicon substrate due to cutting and impurities such as metal residues through solution immersion.

In an embodiment, the rough polishing includes immersing the surface of the silicon substrate using a NaOH solution with a mass concentration of 5.19%.

In some embodiments, the pre-cleaning includes cleaning the surface of the silicon substrate using a mixed solution of strong alkali and hydrogen peroxide.

In an embodiment, the pre-cleaning includes cleaning the surface of the silicon substrate using a mixed solution of a NaOH solution with a mass concentration of 1.12% and a H₂O₂ solution with a mass concentration of 4.66%.

In some embodiments, the polishing includes immersing the pre-cleaned silicon substrate in a hydrofluoric acid solution introduced with ozone, and grinding and polishing the surface of the silicon substrate after immersion.

In an embodiment, a mass concentration of the hydrofluoric acid solution is 0.3%, and a concentration of ozone is 30 ppm.

In some embodiments, the passivation includes performing an oxide removal treatment on the surface of the silicon substrate using a hydrofluoric acid solution. While achieving the oxide removal effect, the passivation can also saturate the dangling bonds on the surface of the silicon substrate with hydrogen, thereby enabling the silicon substrate to obtain good passivation performance during the preparation of the intrinsic amorphous silicon layer.

In an embodiment, a mass concentration of hydrofluoric acid is 5.35%.

In some embodiments, a thickness of each of the two intrinsic amorphous silicon layers is 5 nm to 10 nm. Optionally, the thickness of each of the two intrinsic amorphous silicon layers is 5 nm, 5.5 nm, 6 nm, 6.5 nm, 7 nm, 7.5 nm, 8 nm, 8.5 nm, 9 nm, 9.5 nm, or 10 nm.

In some embodiments, after performing texturing on the surfaces of the n-type microcrystalline doped layer and the p-type microcrystalline doped layer, the method further includes: preparing a transparent conductive oxide layer on surfaces of the textured n-type microcrystalline doped layer and the textured p-type microcrystalline doped layer.

In some embodiments, the transparent conductive oxide layer is prepared by deposition.

In some embodiments, after preparing the transparent conductive oxide layer on the surfaces of the textured n-type microcrystalline doped layer and the textured p-type microcrystalline doped layer, the method further includes: preparing an electrode layer on a surface of the transparent conductive oxide layer.

In some embodiments, the electrode layer is prepared by screen printing.

In some embodiments, the method for preparing a solar cell includes:
(1) providing a silicon substrate with untextured surfaces;
(2) performing rough polishing, pre-cleaning, polishing, and passivation on the untextured silicon substrate sequentially;
(3) preparing intrinsic amorphous silicon layers on both surfaces of the untextured silicon substrate;
(4) preparing an n-type microcrystalline doped layer and a p-type microcrystalline doped layer on surfaces of the two intrinsic amorphous silicon layers, respectively;
(5) performing texturing on surfaces of the n-type microcrystalline doped layer and the p-type microcrystalline doped layer;
(6) treating the textured surfaces of the n-type microcrystalline doped layer and the p-type microcrystalline doped layer with a mixed solution of HCl and H₂O₂ and an HF solution sequentially;
(7) preparing a transparent conductive oxide layer on the treated textured surfaces of the n-type microcrystalline doped layer and the p-type microcrystalline doped layer; and
(8) preparing an electrode layer on a surface of the transparent conductive oxide layer.

In an embodiment, the method for preparing a solar cell includes the following steps:
(1) providing a silicon substrate with untextured surfaces;
(2) performing rough polishing, pre-cleaning, polishing, and passivation on the untextured silicon substrate sequentially;
(3) preparing intrinsic amorphous silicon layers on both surfaces of the untextured silicon substrate;
(4) preparing an n-type amorphous doped sublayer and a p-type amorphous doped sublayer on the surfaces of the two intrinsic amorphous silicon layers, respectively;
(5) preparing an n-type microcrystalline growth sublayer on the n-type amorphous doped sublayer, and preparing a p-type microcrystalline growth sublayer on the p-type amorphous doped sublayer;
(6) preparing an n-type microcrystalline doped sublayer on the n-type microcrystalline growth sublayer, and preparing a p-type microcrystalline doped sublayer on the p-type microcrystalline growth sublayer;
(7) performing texturing on surfaces of the n-type microcrystalline doped sublayer and the p-type microcrystalline doped sublayer;
(8) treating the textured surfaces of the n-type microcrystalline doped sublayer and the p-type microcrystalline doped sublayer with a mixed solution of HCl and H₂O₂ and an HF solution sequentially;
(9) preparing a transparent conductive oxide layer on the treated textured surfaces of the n-type microcrystalline doped sublayer and the p-type microcrystalline doped sublayer; and
(10) preparing an electrode layer on a surface of the transparent conductive oxide layer.

In an embodiment, the method for preparing a solar cell consists of the following steps:
(1) providing a silicon substrate with untextured surfaces;
(2) performing rough polishing, pre-cleaning, polishing, and passivation on the untextured silicon substrate sequentially;
(3) preparing intrinsic amorphous silicon layers on both surfaces of the untextured silicon substrate;
(4) preparing an n-type amorphous doped sublayer and a p-type amorphous doped sublayer on the surfaces of the two intrinsic amorphous silicon layers, respectively;
(5) preparing an n-type microcrystalline growth sublayer on the n-type amorphous doped sublayer, and preparing a p-type microcrystalline growth sublayer on the p-type amorphous doped sublayer;
(6) preparing an n-type microcrystalline doped sublayer on the n-type microcrystalline growth sublayer, and preparing a p-type microcrystalline doped sublayer on the p-type microcrystalline growth sublayer;
(7) performing texturing on surfaces of the n-type microcrystalline doped sublayer and the p-type microcrystalline doped sublayer;
(8) treating the textured surfaces of the n-type microcrystalline doped sublayer and the p-type microcrystalline doped sublayer with a mixed solution of HCl and H₂O₂ and an HF solution sequentially;
(9) preparing a transparent conductive oxide layer on the treated textured surfaces of the n-type microcrystalline doped sublayer and the p-type microcrystalline doped sublayer; and
(10) preparing an electrode layer on a surface of the transparent conductive oxide layer.

Referring to FIG. 2, another embodiment of the present disclosure provides a solar cell, including: a untextured silicon substrate; intrinsic amorphous silicon layers respectively disposed on both surfaces of the non-textured silicon substrate; and an n-type microcrystalline doped layer and a p-type microcrystalline doped layer respectively disposed on surfaces of the two intrinsic amorphous silicon layers away from the untextured silicon substrate, wherein surfaces of the n-type microcrystalline doped layer and the p-type microcrystalline doped layer away from the untextured silicon substrate are textured surfaces.

In some embodiments, the n-type microcrystalline doped layer includes an n-type amorphous doped sublayer, an n-type microcrystalline growth sublayer, and an n-type microcrystalline doped sublayer sequentially stacked, wherein the n-type amorphous doped sublayer is closer to the untextured silicon substrate than the n-type microcrystalline doped sublayer; and the p-type microcrystalline doped layer includes a p-type amorphous doped sublayer, a p-type microcrystalline growth sublayer, and a p-type microcrystalline doped sublayer sequentially stacked, wherein the p-type amorphous doped sublayer is closer to the untextured silicon substrate than the p-type microcrystalline doped sublayer.

In some embodiments, a thickness of the n-type microcrystalline doped sublayer is 0.5 µm to 1 µm. Optionally, the thickness of the n-type microcrystalline doped sublayer is 0.5 µm, 0.55 µm, 0.6 µm, 0.65 µm, 0.7 µm, 0.75 µm, 0.8 µm, 0.85 µm, 0.9 µm, or 1 µm.

In some embodiments, a thickness of the p-type microcrystalline doped sublayer is 0.5 µm to 1 µm. Optionally, the thickness of the p-type microcrystalline doped sublayer is 0.5 µm, 0.55 µm, 0.6 µm, 0.65 µm, 0.7 µm, 0.75 µm, 0.8 µm, 0.85 µm, 0.9 µm, or 1 µm.

In some embodiments, the textured surface has a plurality of pyramid structures, and a height of the pyramid structure is 0.5 µm to 1 µm. Within this height range of the pyramid structures, the light trapping effect is good. Optionally, the height of the pyramid structure is 0.5 µm, 0.55 µm, 0.6 µm, 0.65 µm, 0.7 µm, 0.75 µm, 0.8 µm, 0.85 µm, 0.9 µm, or 1 µm.

In some embodiments, a transparent conductive oxide layer is further disposed on the surfaces of the n-type microcrystalline doped layer and the p-type microcrystalline doped layer away from the substrate.

In some embodiments, an electrode layer is disposed on the surface of the transparent conductive oxide layer.

Specific examples are shown below.

### Example 1

The structure of a solar cell is as follows.

Referring again to FIG. 2, the solar cell includes an untextured silicon substrate 100. The silicon substrate 100 includes a front surface and a back surface. The front surface of the silicon substrate 100 is provided with an n-type intrinsic amorphous silicon layer 210, an n-type microcrystalline incubation sublayer 310, an n-type microcrystalline doped sublayer 410, a front transparent conductive oxide layer 510, and a front electrode layer 610 sequentially stacked thereon. The n-type intrinsic amorphous silicon layer 210 is closer to the silicon substrate 100 than the front electrode layer 610. The n-type microcrystalline incubation sublayer 310 includes an n-type amorphous doped sublayer and an n-type microcrystalline growth sublayer stacked thereon. The n-type amorphous doped sublayer is closer to the n-type intrinsic amorphous silicon layer 210 than the n-type microcrystalline growth sublayer. The back surface of the substrate is provided with a p-type intrinsic amorphous silicon layer 220, a p-type microcrystalline incubation sublayer 320, a p-type microcrystalline doped sublayer 420, a back transparent conductive oxide layer 520, and a back electrode layer 620 sequentially stacked thereon. The p-type intrinsic amorphous silicon layer 220 is closer to the silicon substrate 100 than the back electrode layer 620. The p-type microcrystalline incubation sublayer 320 includes a p-type amorphous doped sublayer and a p-type microcrystalline growth sublayer stacked thereon. The p-type amorphous doped sublayer is closer to the p-type intrinsic amorphous silicon layer 220 than the p-type microcrystalline growth sublayer.

The method for preparing the solar cell is as follows.
(1) An n-type monocrystalline silicon wafer with untextured surfaces was provided.
(2) Rough polishing, pre-cleaning, polishing, and passivation were performed sequentially on the surface of the untextured n-type monocrystalline silicon wafer. The rough polishing was performed by immersing the surface of the silicon substrate 100 using a NaOH solution with a mass concentration of 5.19%. The pre-cleaning was performed by cleaning the surface of the silicon substrate 100 using a mixed solution of a NaOH solution with a mass concentration of 1.12% and a H₂O₂ solution with a mass concentration of 4.66%. The polishing was performed by immersing the pre-cleaned silicon substrate 100 in a hydrofluoric acid solution introduced with ozone, the mass concentration of the hydrofluoric acid solution being 0.3% and the concentration of ozone being 30 ppm, and after immersion, grinding and polishing the surface of the silicon substrate 100. The passivation was to perform an oxide removal treatment on the surface of the silicon substrate 100 using a hydrofluoric acid solution with a mass concentration of 5.35%.
(3) A front intrinsic amorphous silicon layer was prepared on the front surface of the untextured n-type monocrystalline silicon wafer by plasma chemical vapor deposition. A back intrinsic amorphous silicon layer was prepared on the back surface of the untextured n-type monocrystalline silicon wafer by plasma chemical vapor deposition. The thickness of each of the front intrinsic amorphous silicon layer and the back intrinsic amorphous silicon layer was 5 nm to 10 nm.
(4) An n-type amorphous doped sublayer was prepared on the surface of the front intrinsic amorphous silicon layer by plasma chemical vapor deposition. A p-type amorphous doped sublayer was prepared on the surface of the back intrinsic amorphous silicon layer by plasma chemical vapor deposition. A pressure for the plasma chemical vapor deposition was 0.5 Torr to 0.57 Torr. A volume ratio of the deposition gases for the plasma chemical vapor deposition was SiH₄:H₂=1:15 to 1:30. An ignition power for the plasma chemical vapor deposition was 200 W to 800 W.
(5) By adjusting the parameters for preparation, an n-type microcrystalline growth sublayer was prepared on the surface of the n-type amorphous doped sublayer by plasma chemical vapor deposition, and a p-type microcrystalline growth sublayer was prepared on the surface of the p-type amorphous doped sublayer by plasma chemical vapor deposition. A pressure for the plasma chemical vapor deposition was 3 Torr to 5 Torr. A volume ratio of the deposition gases for the plasma chemical vapor deposition was SiH₄:H₂=1:150 to 1:200. An ignition power of the plasma chemical vapor deposition was 2000 W to 3500 W.
(6) By adjusting the pressure and the ignition power of the plasma chemical vapor deposition, an n-type microcrystalline doped sublayer 410 was prepared on the surface of the n-type microcrystalline growth sublayer by plasma chemical vapor deposition, and a p-type microcrystalline doped sublayer 420 was prepared on the surface of the p-type microcrystalline growth sublayer by plasma chemical vapor deposition. The thickness of each of the n-type microcrystalline doped sublayer 410 and the p-type microcrystalline doped sublayer 420 was 0.5 µm to 1 µm. A pressure for the plasma chemical vapor deposition was 5 Torr to 8 Torr. An ignition power for the plasma chemical vapor deposition was 4000 W to 7000 W.
(7) Using an alkaline solution with a mass concentration of 0.8% to 1% mixed with an alcohol additive, texturing was performed on the surfaces of the n-type microcrystalline doped sublayer 410 and the p-type microcrystalline doped sublayer 420 at 60°C to 65°C.
(8) After texturing, the surfaces of the n-type microcrystalline doped sublayer 410 and the p-type microcrystalline doped sublayer 420 were sequentially treated with a mixed solution of HCl and H₂O₂ and an HF solution.
(9) A front transparent conductive oxide layer 510 was prepared on the surface of the treated n-type microcrystalline doped sublayer 410. A back transparent conductive oxide layer 520 was prepared on the surface of the p-type microcrystalline doped sublayer 420.
(10) A front electrode layer 610 was prepared on the surface of the front transparent conductive oxide layer 510. A back electrode layer 620 was prepared on the surface of the back transparent conductive oxide layer 520.

In the solar cell prepared in this example, the contact effect between the intrinsic amorphous layer and the substrate was good, the n-type microcrystalline doped sublayer 410 and the p-type microcrystalline doped sublayer 420 had high crystalline fractions, the surfaces of the n-type microcrystalline doped sublayer 410 and the p-type microcrystalline doped sublayer 420 were uniformly textured, and the efficiency of the cell was high.

### Comparative Example 1

The method for preparing a solar cell is as follows.
(1) An n-type monocrystalline silicon wafer was provided. Rough polishing, pre-cleaning, polishing, and passivation were performed sequentially on the surface of the n-type monocrystalline silicon wafer. The rough polishing was performed by immersing the surface of the n-type monocrystalline silicon wafer using a NaOH solution with a mass concentration of 5.19%. The pre-cleaning was performed by cleaning the surface of the n-type monocrystalline silicon wafer using a mixed solution of a NaOH solution with a mass concentration of 1.12% and a H₂O₂ solution with a mass concentration of 4.66%. The polishing was performed by immersing the pre-cleaned n-type monocrystalline silicon wafer in a hydrofluoric acid solution introduced with ozone, the mass concentration of the hydrofluoric acid solution being 0.3% and the concentration of ozone being 30 ppm, and after immersion, grinding and polishing the surface of the n-type monocrystalline silicon wafer. The passivation was to perform an oxide removal treatment on the surface of the n-type monocrystalline silicon wafer using a hydrofluoric acid solution with a mass concentration of 5.35%.
(2) Using an alkaline solution with a mass concentration of 1.51% mixed with an alcohol additive, texturing was performed on the surfaces of the oxide-removed n-type monocrystalline silicon wafer at 80°C to 85°C.
(3) A front intrinsic amorphous silicon layer was prepared on the textured front surface of the n-type monocrystalline silicon wafer by plasma chemical vapor deposition. A back intrinsic amorphous silicon layer was prepared on the textured back surface of the n-type monocrystalline silicon wafer by plasma chemical vapor deposition. The thickness of each of the front intrinsic amorphous silicon layer and the back intrinsic amorphous silicon layer was 5 nm to 10 nm.
(4) An n-type amorphous doped sublayer was prepared on the surface of the front intrinsic amorphous silicon layer by plasma chemical vapor deposition. A p-type amorphous doped sublayer was prepared on the surface of the back intrinsic amorphous silicon layer by plasma chemical vapor deposition. A pressure for the plasma chemical vapor deposition was 0.5 Torr to 0.57 Torr. A volume ratio of the deposition gases for the plasma chemical vapor deposition was SiH₄:H₂=1:15 to 1:30. An ignition power for the plasma chemical vapor deposition was 200 W to 800 W.
(5) By adjusting the parameters for preparation, an n-type microcrystalline growth sublayer was prepared on the surface of the n-type amorphous doped sublayer by plasma chemical vapor deposition, and a p-type microcrystalline growth sublayer was prepared on the surface of the p-type amorphous doped sublayer by plasma chemical vapor deposition. A pressure for the plasma chemical vapor deposition was 3 Torr to 5 Torr. A volume ratio of the deposition gases for the plasma chemical vapor deposition was SiH₄:H₂=1:150 to 1:200. An ignition power of the plasma chemical vapor deposition was 2000 W to 3500 W.
(6) A front transparent conductive oxide layer was prepared on the surface of the n-type microcrystalline growth sublayer, and a back transparent conductive oxide layer was prepared on the surface of the p-type microcrystalline growth sublayer.
(7) A front electrode layer was prepared on the surface of the front transparent conductive oxide layer. A back electrode layer was prepared on the surface of the back transparent conductive oxide layer.

The electrical performance of the solar cells prepared in Example 1 and Comparative Example was compared and shown in Table 1.

**Table 1**

| No. | Eₜₐ (%) | V_{oc} (V) | I_{sc} (A) | FF (%) | Rₛ (mΩ) |
|---|---|---|---|---|---|
| Example 1 | 24.71 | 0.7476 | 8.702 | 83.73 | 3.116 |
| Comparative Example 1 | 24.04 | 0.7463 | 8.568 | 82.70 | 3.038 |

It can be seen that the Eₜₐ of the solar cell prepared in Example 1 increased by nearly 0.7% relative to the conventional solar cell with textured silicon substrate, while the Rₛ exhibited a small increase, which was due to the relatively large thicknesses of the n-type microcrystalline doped sublayer and the p-type microcrystalline doped sublayer. Further, V_{oc}, I_{sc}, and FF of the solar cell prepared in Example 1 were all increased, thereby achieving the improvement in E_{ta.}.

The technical features of the above-mentioned embodiments can be combined arbitrarily. In order to make the description concise, not all possible combinations of the technical features in the above-mentioned embodiments are described. However, as long as there is no contradiction in the combination of these technical features, they should be considered to be within the scope of the specification.

## Claims

1. A method for preparing a solar cell, comprising:
providing a silicon substrate with untextured surfaces;
preparing intrinsic amorphous silicon layers on both surfaces of the untextured silicon substrate;
preparing an n-type microcrystalline doped layer and a p-type microcrystalline doped layer on surfaces of the two intrinsic amorphous silicon layers, respectively; and
performing texturing on surfaces of the n-type microcrystalline doped layer and the p-type microcrystalline doped layer.

2. The method according to claim 1, wherein preparing the n-type microcrystalline doped layer and the p-type microcrystalline doped layer on the surfaces of the two intrinsic amorphous silicon layers, respectively, comprises:
preparing an n-type amorphous doped sublayer and a p-type amorphous doped sublayer on the surfaces of the two intrinsic amorphous silicon layers, respectively;
preparing an n-type microcrystalline growth sublayer on the n-type amorphous doped sublayer, and preparing a p-type microcrystalline growth sublayer on the p-type amorphous doped sublayer; and
preparing an n-type microcrystalline doped sublayer on the n-type microcrystalline growth sublayer, and preparing a p-type microcrystalline doped sublayer on the p-type microcrystalline growth sublayer.

3. The method according to claim 1 or 2, wherein performing texturing on the surfaces of the n-type microcrystalline doped layer and the p-type microcrystalline doped layer comprises:
performing texturing on the surfaces of the n-type microcrystalline doped layer and the p-type microcrystalline doped layer at 60°C to 65°C using an alkaline solution with a mass concentration of 0.8% to 1%.

4. The method according to claim 2 or 3, wherein a thickness of the n-type microcrystalline doped sublayer is controlled to be 0.5 µm to 1 µm.

5. The method according to any one of claims 2 to 4, wherein a thickness of the p-type microcrystalline doped sublayer is controlled to be 0.5 µm to 1 µm.

6. The method according to any one of claims 2 to 5, wherein a pressure for preparing the n-type amorphous doped sublayer is 0.5 Torr to 0.57 Torr.

7. The method according to any one of claims 2 to 6, wherein a volume ratio of gases for preparing the n-type amorphous doped sublayer is SiH₄:H₂=1:15 to 1:30.

8. The method according to any one of claims 2 to 7, wherein an ignition power for preparing the n-type amorphous doped sublayer is 200 W to 800 W.

9. The method according to any one of claims 2 to 8, wherein a pressure for preparing the p-type amorphous doped sublayer is 0.5 Torr to 0.57 Torr.

10. The method according to any one of claims 2 to 9, wherein a volume ratio of gases for preparing the p-type amorphous doped sublayer is SiH₄:H₂=1:15 to 1:30.

11. The method according to any one of claims 2 to 10, wherein an ignition power for preparing the p-type amorphous doped sublayer is 200 W to 800 W.

12. The method according to any one of claims 2 to 11, wherein a pressure for preparing the n-type microcrystalline growth sublayer on the n-type amorphous doped sublayer is 3 Torr to 5 Torr.

13. The method according to any one of claims 2 to 12, wherein a volume ratio of gases for preparing the n-type microcrystalline growth sublayer on the n-type amorphous doped sublayer is SiH₄:H₂=1:150 to 1:200.

14. The method according to any one of claims 2 to 13, wherein an ignition power for preparing the n-type microcrystalline growth sublayer on the n-type amorphous doped sublayer is 2000 W to 3500 W.

15. The method according to any one of claims 2 to 14, wherein a pressure for preparing the p-type microcrystalline growth sublayer on the p-type amorphous doped sublayer is 3 Torr to 5 Torr.

16. The method according to any one of claims 2 to 15, wherein a volume ratio of gases for preparing the p-type microcrystalline growth sublayer on the p-type amorphous doped sublayer is SiH₄:H₂=1:150 to 1:200.

17. The method according to any one of claims 2 to 16, wherein an ignition power for preparing the p-type microcrystalline growth sublayer on the p-type amorphous doped sublayer is 2000 W to 3500 W.

18. The method according to any one of claims 2 to 17, wherein a pressure for preparing the n-type microcrystalline doped sublayer on the n-type microcrystalline growth sublayer is 5 Torr to 8 Torr.

19. The method according to any one of claims 2 to 18, wherein an ignition power for preparing the n-type microcrystalline doped sublayer on the n-type microcrystalline growth sublayer is 4000 W to 7000 W.

20. The method according to any one of claims 2 to 19, wherein a pressure for preparing the p-type microcrystalline doped sublayer on the p-type microcrystalline growth sublayer is 5 Torr to 8 Torr.

21. The method according to any one of claims 2 to 20, wherein an ignition power for preparing the p-type microcrystalline doped sublayer on the p-type microcrystalline growth sublayer is 4000 W to 7000 W.

22. The method according to any one of claims 1 to 21, wherein before preparing the intrinsic amorphous silicon layers on both surfaces of the untextured silicon substrate, the method further comprises:
performing rough polishing, pre-cleaning, polishing, and passivation on the untextured silicon substrate sequentially.

23. The method according to any one of claims 1 to 22, wherein a thickness of each of the two intrinsic amorphous silicon layers is controlled to be 5 nm to 10 nm.

24. A solar cell, comprising: a untextured silicon substrate; intrinsic amorphous silicon layers respectively disposed on both surfaces of the non-textured silicon substrate; and an n-type microcrystalline doped layer and a p-type microcrystalline doped layer respectively disposed on surfaces of the two intrinsic amorphous silicon layers away from the untextured silicon substrate, wherein surfaces of the n-type microcrystalline doped layer and the p-type microcrystalline doped layer away from the untextured silicon substrate are textured surfaces.

25. The solar cell according to claim 24, wherein the n-type microcrystalline doped layer comprises an n-type amorphous doped sublayer, an n-type microcrystalline growth sublayer, and an n-type microcrystalline doped sublayer sequentially stacked, wherein the n-type amorphous doped sublayer is closer to the untextured silicon substrate than the n-type microcrystalline doped sublayer; and the p-type microcrystalline doped layer comprises a p-type amorphous doped sublayer, a p-type microcrystalline growth sublayer, and a p-type microcrystalline doped sublayer sequentially stacked, wherein the p-type amorphous doped sublayer is closer to the untextured silicon substrate than the p-type microcrystalline doped sublayer.

26. The solar cell according to claim 25, wherein a thickness of the n-type microcrystalline doped sublayer is 0.5 µm to 1 µm.

27. The solar cell according to claim 25 or 26, wherein a thickness of the p-type microcrystalline doped sublayer is 0.5 µm to 1 µm.

28. The solar cell according to any one of claims 24 to 27, wherein the textured surface has a plurality of pyramid structures, and a height of the pyramid structure is 0.5 µm to 1 µm.
